(19)

Europäisches
Patentamt
European
Patent Office
Office européen
des brevets

(11) **EP 4 561 297 A1**

(12) **EUROPEAN PATENT APPLICATION**

(43) Date of publication:
**28.05.2025 Bulletin 2025/22**

(21) Application number: **24212741.3**

(22) Date of filing: **13.11.2024**

(51) International Patent Classification (IPC):
*H10D 62/10* (2025.01)  *H10D 30/01* (2025.01)
*H10D 30/66* (2025.01)  *H10D 64/00* (2025.01)

(52) Cooperative Patent Classification (CPC):
**H10D 62/105; H10D 30/0297; H10D 30/66;
H10D 30/665; H10D 62/124; H10D 64/117;**
H10D 62/117

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.11.2023 CN 202311507236**

(71) Applicants:
• **Nexperia B.V.**
  **6534 AB Nijmegen (NL)**
• **Nexperia Technology (Shanghai) Ltd.**
  **Shanghai 200025 (CN)**

(72) Inventors:
• **Zhang, Ken**
  **Shanghai (CN)**
• **Zhu, Chunlin**
  **Shanghai (CN)**
• **Yan, Xiaowen**
  **Shanghai (CN)**
• **Jiang, Ke**
  **Shanghai (CN)**

(74) Representative: **Pjanovic, Ilija**
  **Nexperia B.V.**
  **Legal & IP**
  **Jonkerbosplein 52**
  **6534 AB Nijmegen (NL)**

(54) **SEMICONDUCTOR DEVICE AND MANUFACTURING METHOD THEREOF**

(57)     A semiconductor device and a manufacturing method thereof are disclosed. The semiconductor device includes: a substrate having a front surface and a back surface opposite to each other. A main junction region, a terminal region and a field cut-off region are sequentially arranged in the substrate close to the front surface along a first direction parallel with the front surface. At least one trench is formed in the terminal region at a position close to the field cut-off region. Field limiting ring are formed in the terminal region. At least a part of the field limiting rings surround the trench, and a junction depth of the field limiting ring surrounding the trench is greater than a junction depth of the field limiting ring not surrounding the trench. According to the semiconductor device of the present disclosure, by arranging trench structures in the terminal region, the depth of ion implantation can be increased, so that a larger junction depth can be formed subsequently. The larger junction depth can reduce a peak electric field strength on the surface; the peak electric field strength shifts from the surface to the inside of silicon; and the curvature radius of the terminal P-type implantation region is increased, thereby increasing the breakdown voltage of the terminal structure.

FIG. 4

EP 4 561 297 A1

**Description**

**Technical Field**

This application relates to a semiconductor device, and in particular to a power semiconductor device with trenches added and a manufacturing method thereof.

**Background**

Nowadays, a cell of a power device can be designed to achieve a high level of withstand voltage, but in the actual production process, the influence of the edge region around the cell on the withstand voltage of the device also needs to be considered. For a power device with a vertical structure, the cells at the edge of a chip have to withstand the voltage in the vertical direction as well as the voltage in the horizontal direction, so the terminal edge region of the device becomes a non-negligible factor in restricting the breakdown voltage (BV) of the whole device.

**Summary**

In order to achieve a higher breakdown voltage, this application provides a semiconductor device and a manufacturing method thereof.

One aspect of the present disclosure provides a semiconductor device, including: a substrate having a front surface and a back surface opposite to each other; a main junction region, a terminal region and a field cut-off region sequentially arranged in the substrate close to the front surface along a first direction parallel with the front surface; and at least one trench formed in the terminal region at a position close to the field cut-off region. Field limiting ring are formed in the terminal region. At least a part of the field limiting rings surround the trench, and a junction depth of the field limiting ring surrounding the trench is greater than a junction depth of the field limiting ring not surrounding the trench.

In some embodiments, the terminal region is the variable lateral doping terminal region, and the variable lateral doping terminal region includes the plurality of field limiting rings. A distance between a peak of a first field limiting ring surrounding the trench and closest to the main junction region and a peak of a second field limiting ring adjacent to the first field limiting ring but not surrounding the trench is T, and a distance between the peak of the second field limiting ring and a peak of a third field limiting ring in close proximity to the second field limiting ring but not surrounding the trench is D. A ratio T/D of the distance T to the distance D is greater than 0 and less than 0.35 or greater than 1 and less than 1.5. Preferably, the ratio T/D of the distance T to the distance D is greater than 0 and less than 0.2 or greater than 1 and less than 1.3.

In some embodiments, the terminal region is the variable lateral doping terminal region, and the variable lateral doping terminal region includes the plurality of field limiting rings. A curvature of the field limiting ring surrounding the trench changes at a position corresponding to a trench sidewall of the trench closest to the main junction region. Preferably, the curvature decreases.

In some embodiments, the terminal region is the variable lateral doping terminal region, and the variable lateral doping terminal region includes the plurality of field limiting rings. An orientation of a curvature radius of the field limiting ring surrounding the trench deviates at a position corresponding to a trench sidewall of the trench closest to the main junction region. Preferably, the orientation of the curvature radius of the field limiting ring surrounding the trench starts to deviate from the position corresponding to the trench sidewall of the trench closest to the main junction region.

In some embodiments, the terminal region is the variable lateral doping terminal region, and the variable lateral doping terminal region includes the plurality of field limiting rings. A width of the trench is less than the distance between the peaks of the second field limiting ring and the third field limiting ring not surrounding the trench but adjacent to the first field limiting ring surrounding the trench and closest to the main junction region.

In some embodiments, there are two or more trenches sequentially arranged from the position of the terminal region close to the field cut-off region to the position close to the main junction region. Preferably, spacings between the adjacent two trenches are the same; or monotonically increase, monotonically decrease, or increase first and then decrease along the first direction toward the field cut-off region. Preferably, the spacings between the two adjacent trenches are 0.3-6 $\mu$m, preferably 0.5-4 $\mu$m.

In some embodiments, depths of the plurality of trenches are the same; or monotonically increase, monotonically decrease, or increase first and then decrease along the first direction toward the field cut-off region. Preferably, widths of the plurality of trenches are the same; or monotonically increase, monotonically decrease, or increase first and then decrease along the first direction toward the field cut-off region.

In some embodiments, the depths of the trenches are 1-8 $\mu$m, preferably 2-6 $\mu$m, and the widths of the trenches are 0.4-8 $\mu$m, preferably 0.6-5 $\mu$m.

Another aspect of the present disclosure provides a method for manufacturing a semiconductor device, including the following steps: providing a substrate having a front surface and a back surface opposite to each other; forming at least one trench in the front surface of the substrate corresponding to a position in a terminal region close to a field cut-off region; and sequentially implanting ions in the front surface of the substrate along a first direction parallel with the front surface to form a main junction region, the terminal region and the field cut-off region. Field limiting rings are formed in the terminal region. At least a part of the field limiting rings surround the trench, and a junction depth of the field limiting ring surrounding the trench is greater than a junction depth of the field limiting ring not surrounding the trench.

In some embodiments, the manufacturing method further includes: performing junction pushing on the main junction region, the terminal region and the field cut-off region by heat diffusion such that the junction depths of all the field limiting rings in the terminal region are further increased, and the junction depth of the field limiting ring surrounding the trench is greater than the junction depth of the field limiting ring not surrounding the trench.

In some embodiments, the terminal region is a variable lateral doping terminal region, and the variable lateral doping terminal region includes a plurality of field limiting rings arranged side by side from a side close to the field cut-off region to a side of the main junction region along the first direction. The plurality of field limiting rings are formed by the following steps: arranging a plurality of masks on the front surface of the substrate at intervals at positions corresponding to the terminal region; and

implanting ions through implantation windows between the adjacent masks to form the plurality of field limiting rings, where the trench is formed in the implantation window on the side close to the field cut-off region before the ions are implanted.

In some embodiments, the trench is formed in one of the windows or in each of the plurality of windows.

In some embodiments, the trench is formed to span two adjacent implantation windows. Preferably, a width of the trench is greater than a width of the mask and less than 50% of a sum of widths of the two adjacent implantation windows spanned by the trench.

In some embodiments, the terminal region is a junction termination extension terminal region, and the trench is formed in a central region of the junction termination extension terminal region.

According to the semiconductor device of the present disclosure, by arranging trench structures in the terminal region, the depth of ion implantation can be increased, so that a larger junction depth can be formed subsequently. The larger junction depth can reduce a peak electric field strength on the surface; the peak electric field strength shifts from the surface to the inside of silicon; and the curvature radius of the terminal P-type implantation region is increased, thereby increasing the breakdown voltage of the terminal structure.

## Brief Description of Figures

FIG. 1 show a schematic structural view of a semiconductor device according to a first embodiment of the present disclosure;

FIG. 2 shows a schematic structural view of a semiconductor device according to a second embodiment of the present disclosure;

FIG. 3 shows a schematic structural view of the semiconductor device formed with a field oxide layer according to the first embodiment of the present disclosure;

FIG. 3A shows a partial enlarged view of FIG. 3;

FIG. 4 shows a schematic structural view of the semiconductor device formed with a field oxide layer according to the second embodiment of the present disclosure;

FIG. 5 shows a schematic structural view of the semiconductor device formed with an active area trench structure according to the first embodiment of the present disclosure;

FIG. 6 shows a schematic structural view of the semiconductor device formed with an active area trench structure according to the second embodiment of the present disclosure;

FIG. 7 shows a schematic structural view of the semiconductor device formed with an N source region and a front surface metal layer according to the first embodiment of the present disclosure;

FIG. 8 shows a schematic structural view of the semiconductor device formed with an N source region and a front surface metal layer according to the second embodiment of the present disclosure;

FIG. 9 shows a schematic structural view of the semiconductor device with only the field oxide layer being formed in the trench according to the second embodiment of the present disclosure;

FIG. 10 shows a schematic structural view of a terminal region not formed with a trench in the related art;

FIG. 11 shows a schematic structural view of a terminal region formed with a trench in the present disclosure;

FIG. 12 shows a breakdown voltage comparison diagram of the terminal region structure not formed with a trench in the related art in FIG. 10 and the terminal region structure formed with a trench in the present disclosure in FIG. 11;

FIG. 13 shows an electric field distribution diagram of the terminal region structure not formed with a trench in the related art in FIG. 10;

FIG. 14 shows an electric field distribution diagram of the terminal region structure formed with a trench in the present disclosure in FIG. 11;

FIG. 15 shows a breakdown voltage comparison diagram of the terminal region structure not formed with a trench in the related art and the terminal region structure formed with a trench with different depths in the present disclosure;

FIG. 16 shows an electric field distribution diagram of the terminal region structure not formed with a trench in the related art;

FIG. 17 shows an electric field distribution diagram of the terminal region structure formed with a trench with a depth of 4 $\mu$m in the present disclosure;

FIG. 18 shows an electric field distribution diagram of the terminal region structure formed with a trench with a depth of 5 $\mu$m in the present disclosure;

FIG. 19 shows an electric field distribution diagram of the terminal region structure formed with a trench with a depth of 3 $\mu$m in the present disclosure;

FIG. 20 shows a breakdown voltage comparison diagram of the terminal region structure not formed with a trench in the related art and the terminal region structure formed with a plurality of trenches in the present disclosure;

FIG. 21 shows an electric field distribution diagram of the terminal region structure not formed with a trench in the related art;

FIG. 22 shows an electric field distribution diagram of the terminal region structure formed with a plurality of trenches in the present disclosure, where spacings between the trenches are kept constant and widths of the trenches gradually decrease from left (close to the active area) to right (close to the field cut-off region);

FIG. 23 shows an electric field distribution diagram of the terminal region structure formed with a plurality of trenches in the present disclosure, where spacings between the trenches are kept constant and widths of the trenches gradually increase from left (close to the active area) to right (close to the field cut-off region);

FIG. 24 shows a curvature radius of a spherical junction of the terminal region structure not formed with a trench in the related art;

FIG. 25 shows a curvature radius of a spherical junction of the terminal region structure formed with 5 trenches in the present disclosure;

FIG. 26 shows a curvature radius of a spherical junction of the terminal region structure formed with 4 trenches in the present disclosure;

FIG. 27 shows a curvature radius of a spherical junction of the terminal region structure formed with 3 trenches in the present disclosure; and

FIG. 28 shows a schematic structural view of a JTE terminal region.

## Detailed Description

In order to make those skilled in the art better understand the technical solutions of the present disclosure, as a non-limiting example, an adaptive bushing system provided by the present disclosure will be described in detail with reference to the accompanying drawings.

It should also be noted that in order to illustrate these exemplary embodiments here, the views will show the general features of the system of the exemplary embodiments of the present disclosure. However, these views are not to scale and may not accurately reflect the features of any given embodiment, and should not be interpreted as defining or limiting the numerical range or characteristics of exemplary embodiments within the scope of the present disclosure.

In this specification, the back surface of the semiconductor substrate is considered to be formed by the lower or back side surface of the semiconductor substrate, and the front surface is considered to be formed by the upper, front or main surface of the semiconductor substrate. Therefore, in consideration of this orientation, the terms "above" and "below" as used in this specification describe the relative position of a structural feature with respect to another structural feature.

One aspect of the present disclosure provides a semiconductor device.

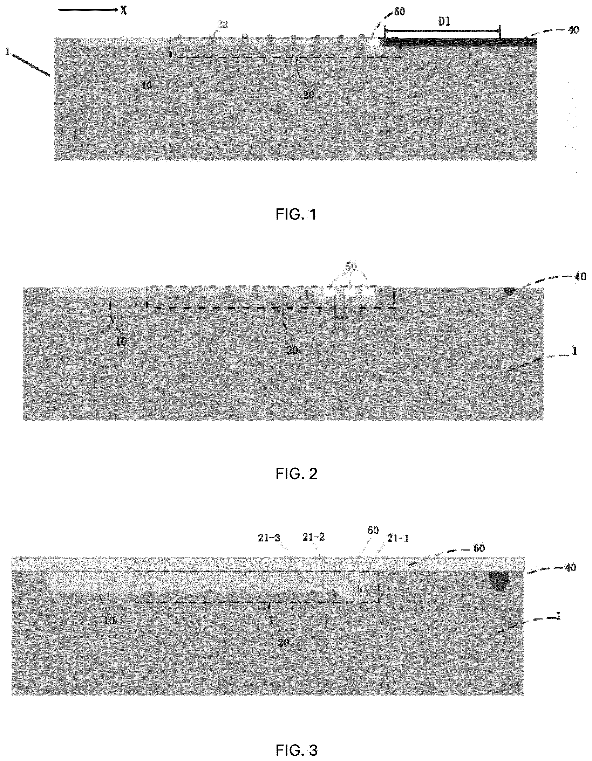

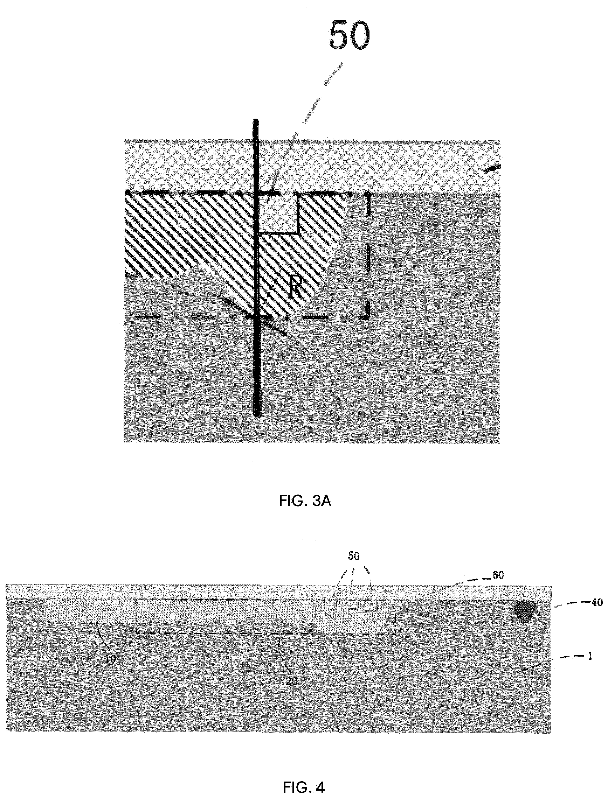

FIG. 1 show a schematic structural view of a semiconductor device according to a first embodiment of the present disclosure, a schematic view after a main junction region, a terminal region and a field cut-off region are implanted but before heat diffusion is performed. FIG. 3 shows a schematic structural view of the semiconductor device after the main junction region, the terminal region and the field cut-off region are implanted and after the heat diffusion is performed. The semiconductor device of this application includes: a substrate 1 having a front surface and a back surface opposite to each other. A main junction region 10, a terminal region 20 and a field cut-off region 40 are sequentially arranged in the substrate 1 close to the front surface along a first direction X parallel with the front surface, and for example, in FIG. 1 and FIG. 3, the main junction region 10, the terminal region 20 and the field cut-off region 40 are sequentially arranged from left to right. Alternatively, the first direction X may also be a radial direction, i.e., the main junction region is arranged at the center of the chip, and the terminal region and the field cut-off region are sequentially arranged around the main junction region. Alternatively, the main junction region may be arranged at the center, the terminal regions are arranged on two sides of the main junction region, and the field cut-off regions are arranged on outer sides of the terminal regions. At least one trench 50 is formed in the terminal region 20 at a position close to the field cut-off region 40. For example, there may be 1 trench 50 formed, or there may be 3, 5 or more trenches 50 formed.

Field limiting rings 21 are formed in the terminal region 20. In the terminal region 20, after doping implantation is performed from the front surface of the semiconductor and heat diffusion (junction pushing by annealing) is performed, a doping profile with a certain depth and distribution pattern is formed along a thickness direction (Y direction perpendicular to the first direction X in FIG. 1) of the semiconductor device, also called a field limiting ring in this application, i.e., the parts in the dashed boxes in FIG. 1 and FIG. 3. The field limiting ring itself is a doped region. Since the ring is formed by multistage implantation, a PN junction is formed at the junction between the doped region and the substrate 1. The PN junction is an important structure in a diode, including a P-type semiconductor and an N-type semiconductor. When the diode is forward-biased, an electric field is formed at the sidewall of the PN junction, and this electric field causes electrons implanted into the P-region to be bounced back into the P-region at the sidewall of the PN junction. The doped region is formed by ion implantation and heat diffusion, so that an electric field region capable of limiting the current flow can be formed, and this is the so-called field limiting ring.

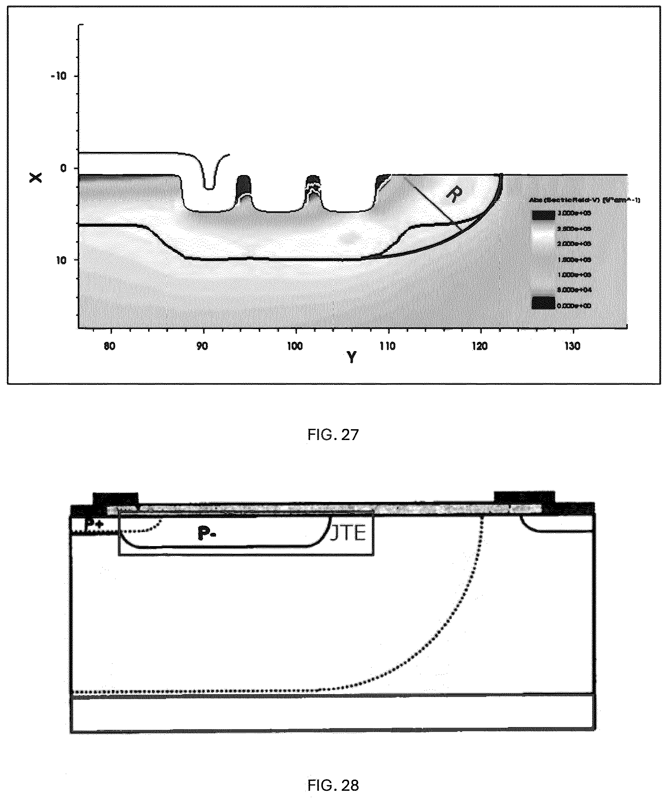

In the terminal region 20 shown in FIG. 3, a plurality of field limiting rings 21 are formed, such as 21-1, 21-2 and 21-3. However, there may also be only one large field limiting ring formed in the terminal region, as shown in FIG. 28, and this will be described in detail below.

In order to improve the withstand voltage capability of the terminal region 20 of the device, the field limiting ring 21 of the terminal region has different distribution patterns according to different doping implantation techniques used in the terminal region 20. In the current market, variable lateral doping (VLD) and junction termination extension (JLE) are commonly used to form the doping profile of the terminal region 20. The VLD is to adjust the spacing between the implantation window of deep well impurities and the mask to form a gradual P-type lightly doped region at the terminal, i.e., form a plurality of field limiting rings (also referred to as VLD field limiting rings) overlapping with each other. Under reverse bias, the curvature radius of the boundary of the depletion layer in the terminal region becomes larger. Doping concentrations of the plurality of field limiting rings may monotonically increase, monotonically decrease, or increase first and then decrease along the first direction toward the field cut-off region. The basic principle of VLD is that different sizes of doping implantation windows will cause different impurity concentrations and junction depths in the doped region after annealing. Using this phenomenon to form a P-type region with varying doping concentration and junction depth laterally can improve the electric field of the main junction, reduce the chip area and increase the withstand voltage ratio of the terminal.

As shown in FIG. 28, the JTE terminal is shown in the gray box (P-region), and mainly formed by a lightly-doped deep-junction P-type semiconductor (Boron, etc.). The JTE is generally in the form of a large junction, i.e., forms a large field limiting ring, and in this large field limiting ring, the doping concentration changes along the first direction.

In this application, at least a part of the field limiting rings 21 surround the trench 50. For example, in a case that the terminal region 20 includes a plurality of field limiting rings, each trench is surrounded by at least one corresponding field limiting ring, as shown in FIG. 3. In the case of JTE where the terminal region 20 includes only one large field limiting ring, at least a part of the field limiting ring surrounds the trenches, and for example, the trenches are formed on the right side of the field limiting ring.

A PN junction is formed at the junction between the field limiting ring of the terminal region 20 and the substrate 1. A depth of the PN junction is a junction depth of the field limiting ring of the terminal region 20, and the junction depth of the field limiting ring is a vertical distance from the lowest end of the field limiting ring to the front surface of the substrate. A junction depth of the field limiting ring surrounding the trench is greater than a junction depth of the field limiting ring not surrounding the trench. For example, in the schematic views of the semiconductor device shown in FIG. 3 and FIG. 4 after the main junction region 10, the terminal region 20 and the field cut-off region 40 are implanted and heat diffusion is performed, a junction depth h1 of the field limiting ring surrounding the trench 50 is greater than a junction depth of the remaining field limiting ring not surrounding the trench 50.

The inventors have found that the maximum electric field is generally located at the junction between silicon and silicon dioxide, the junction is a weak point that affects the stability of breakdown voltage, and the impact of charges may lead to an instable breakdown voltage. In addition, a curvature radius of four corners (spherical junctions) of the chip is also a bottleneck in increase of the breakdown voltage. Therefore, in order to effectively improve the withstand voltage capability of the terminal region, in an example of the present disclosure, a trench structure is formed in the terminal region 20. This trench structure is located at the right end of the terminal region 20 shown in FIG. 1, i.e., at the side adjacent to the field cut-off region 40. Since the terminal region 20 is generally at a certain distance D1 from the field cut-off region 40, the trench structure is also at a certain distance from the field cut-off region 40. Those skilled in the art may adjust the distance D1 between the terminal region 20 and the field cut-off region 40 according to required performance. For example, in a case that a voltage of 600 V is to be achieved, the distance D1 may be about 50 $\mu$m. If the voltage to be achieved by the device is higher, the distance D1 will be increased accordingly.

For the VLD, according an embodiment of the present disclosure, arranging the trench structure and then performing ion implantation by the VLD at the position corresponding to the VLD field limiting ring can increase the depth of ion implantation, so that a larger junction depth can be formed subsequently. Similarly, arranging the trench structure and then performing ion implantation by JTE technology at the position corresponding to the JTE field limiting ring can also increase the depth of ion implantation, so that a larger junction depth can be formed subsequently. The larger junction depth can reduce a peak electric field strength on the surface; the peak electric field strength shifts from the surface to the inside of silicon; and the curvature radius of the P-type implantation region of the terminal region is increased, thereby increasing the breakdown voltage (BV) of the terminal structure.

In some embodiments, as shown in FIG. 1 to FIG. 4, the terminal region is a variable lateral doping terminal region, i.e. a terminal region formed by variable lateral doping. The variable lateral doping terminal region includes a plurality of field limiting rings, and these field limiting rings may overlap with each other.

As shown in FIG. 3 and FIG. 4, a distance between a peak of a first field limiting ring 21-1 surrounding the trench 50 and closest to the main junction region and a peak of a second field limiting ring 21-2 adjacent to the first field limiting ring 21-1 but not surrounding the trench is T, and a distance between the peak of the second field limiting ring 21-2 and a peak of a third field limiting ring 21-3 in close proximity to the second field limiting ring 21-2 but not surrounding the trench is D. A ratio T/D of the distance T to the distance D is greater than 0 and less than 0.35 or greater than 1 and less than 1.5. The ratio T/D in the above range means that the trench is formed to span two adjacent implantation windows and the doping profile in the field limiting ring has a continuous and uniform distribution pattern, and this contributes to uniformity of charges and thus contributes to the reverse withstand voltage capability of the device. The peak of the field limiting ring is the farthest of the edge contour of the field limiting ring from the front surface of the substrate. The first field limiting ring 21-1 surrounding the trench may also be described as the first field limiting ring 21-1 formed with the trench therein. The second field limiting ring 21-2 not surrounding the trench may also be described as the second field limiting ring 21-2 not formed with the trench therein. This arrangement makes the doping concentration corresponding to the left boundary of the trench change suddenly and also makes the diffusion coefficient of the doping element in the oxide layer inside the trench much smaller than that of silicon, and this can be considered that the presence of the trench prevents the doping element from diffusing to the right.

In some preferred embodiments, the ratio T/D of the distance T to the distance D is greater than 0 and less than 0.2 or greater than 1 and less than 1.3. Forming the trench in this range can ensure that the doping profile in the field limiting ring has a continuous and uniform distribution pattern, and this contributes to uniformity of charges and thus contributes to the reverse withstand voltage capability of the device.

In some embodiments, as shown in FIG. 3 and FIG. 4, the terminal region 20 is a variable lateral doping terminal region, and a curvature of the field limiting ring surrounding the trench 50 changes at a position corresponding to a trench sidewall of the trench closest to the main junction region 10. The field limiting ring not surrounding the trench has a substantially semicircular edge contour, and the position of the peak of the field limiting ring formed by implantation in the region with the trench shifts downward so as to form a substantially elliptical edge contour, so that the curvature changes.

Preferably, the curvature decreases, and the curvature radius increases, so that the breakdown voltage can be increased.

In some embodiments, the terminal region 20 is a variable lateral doping terminal region, and an orientation of a curvature radius of the field limiting ring surrounding the trench 50 deviates at a position corresponding to a trench sidewall of the trench closest to the main junction region. The orientation of the curvature radius of the field limiting ring not surrounding the trench at the crest and the trough is vertically upward or downward. When the ion implantation is hindered by the presence of the boundary of the trench, the curvature of the field limiting ring changes at the position corresponding to the boundary of the trench. In this case, the orientation of the curvature radius R of the field limiting ring deviates at the position corresponding to the boundary of the trench, i.e., tilts relative to the vertical direction, as shown in FIG. 3A.

Preferably, the orientation of the curvature radius of the field limiting ring surrounding the trench starts to deviate from the position corresponding to the trench sidewall of the trench 50 closest to the main junction region 10. That is, in the case that a plurality of trenches are formed, from the leftmost trench to the rightmost trench, the orientations of the curvature radiuses of all the field limiting rings surrounding the trenches deviate. This is the reflection of curvature change in the orientation of the curvature radius.

In some embodiments, the terminal region 20 is a variable lateral doping terminal region, and a width of the trench 50 is less than the distance between the peaks of the second field limiting ring and the third field limiting ring not surrounding the trench but adjacent to the first field limiting ring surrounding the trench and closest to the main junction region. For example, as shown in FIG. 3, the width of the trench 50 is less than the distance T between the peaks of the second field limiting ring 21-2 and the third field limiting ring 21-3, i.e., the degree of overlapping of the trench with the field limiting rings spanned by the trench along the first direction is less than 50%. Here, the widths of the first, second and third field limiting rings are considered to be substantially the same as each other. The purpose of this limitation is to make the doping concentration of the ring implanted at the bottom of the trench less than or equal to the doping concentration of the ring implanted near the trench after the addition of the trenches. The total doping content Q1 of the ring near the trench is greater than the total doping content Q2 of the ring at the bottom of the trench. After the subsequent junction pushing is completed, Q1 and Q2 diffuse with each other and merge into a large junction, and this can better protect the sidewall and bottom of the trench.

In some embodiments, there may be two or more trenches 50 sequentially arranged from the position of the terminal region close to the field cut-off region to the position close to the main junction region. For example, there are 3 trenches 50 provided in the structure of the semiconductor device of the second embodiment shown in FIG. 2. Of course, there may be, for example, 4, 6 or more trenches provided, and this is not limited here. By providing two or more trenches, the VLD region (variable lateral doping terminal region) or the JTE region (the junction termination extension terminal region) can have a larger junction depth within a wider range along the first direction, so that the withstand voltage capability of the terminal region can be improved more effectively. These trenches are preferably provided in the right part of the VLD region or the JTE region along the first direction, and more preferably in the right 1/3 part of the terminal region along the first direction. In the case of the JTE region, these trenches are also located in the right part of the JTE region, for example, preferably in the right 1/3 part of the terminal region, and this can increase the curvature radius of the cylindrical junction or spherical junction, thus increasing the BV.

In some embodiments, in the case where there are a plurality of trenches, spacings between the adjacent two trenches are the same, i.e., spacings between every two adjacent trenches are the same; or may monotonically increase or monotonically decrease along the first direction toward the field cut-off region. Alternatively, for example, in the case where there are 5 trenches, the spacings between the two adjacent trenches increase first and then decrease. The combination of the change in the spacings between the trenches with the doping concentration of the terminal region can optimize the electric field distribution of the device and alter the focusing of the surface electric field. Of course, the spacings between the adjacent trenches are not limited to the above, and for example, may also decrease first and then increase.

In some embodiments, the spacings D2 between the two adjacent trenches 50 are 0.3-6 $\mu$m. The adjustment of the spacings between the trenches can optimize the electric field distribution and the position of the breakdown point of the device, and the above spacing range is more beneficial to optimizing the electric field distribution and the position of the breakdown point of the device. The spacing between two adjacent trenches is the length between two adjacent end points of two adjacent trenches along the front surface of the substrate in the X direction. As shown in FIG. 2, for example, the spacing D2 between the left first trench and the left second trench is the linear distance between the right side of the first trench and the left side of the second trench along the front surface of the substrate.

In some preferred embodiments, the spacings between the two adjacent trenches are 0.5-4 $\mu$m.

In some embodiments, depths of the plurality of trenches 50 are the same, as shown in FIG. 2; or monotonically increase, monotonically decrease, or increase first and then decrease along the first direction toward the field cut-off region. Of course, the depths between the trenches are not limited to the above, and for example, may also decrease first and then increase. For example, in FIG. 2, the trenches include a first trench, a second trench, a third trench, a fourth trench and a fifth trench from left to right. The depths of these trenches gradually increase or gradually decrease from the first trench to the fifth trench, or gradually increase from the first trench to the third trench and then gradually decrease from the third trench. Of course, the dividing point of the increase or decrease is not necessarily the trench located in the middle of several trenches.

In some embodiments, widths of the plurality of trenches 50 are the same, as shown in FIG. 2; or monotonically increase, monotonically decrease, or increase first and then decrease along the first direction toward the field cut-off region. The change of the widths of the trenches can affect the depths of the trenches so as to change the junction depth distribution at the bottom of the trench region, thereby optimizing the electric field distribution. Similarly, the widths of the trenches may also decrease first and then increase.

The depth and width of the trench 50 structure need to be such that the formed trench 50 can be surrounded by the field limiting ring 21 finally formed by the VLD, that is, the distribution edge of the field limiting ring surrounding the trench is continuous. In some embodiments, the depths of the trenches 50 are 1-8 $\mu$m, and the widths of the trenches 50 are 0.4-8 $\mu$m. The depth of the trench 50 is the vertical distance from the deepest position of the trench to the front surface of the substrate. The width of the trench 50 is the distance between the two sides of each trench along the front surface of the substrate. Within the above range, the larger the depth of the trench 50, the larger the junction depth, and the larger the curvature radius. A larger curvature radius can increase the upper limit of the breakdown voltage of the spherical junction and cylindrical junction.

In some preferred embodiments, the depths of the trenches 50 are 2-6 $\mu$m. The depth of the trench 50 within this range is more beneficial to increasing the upper limit of the breakdown voltage of the spherical junction and cylindrical junction.

In some preferred embodiments, the widths of the trenches 50 are 0.6-5 $\mu$m. The width of the trench 50 within this range is also more beneficial to increasing the upper limit of the breakdown voltage of the spherical junction and cylindrical junction.

In some preferred embodiments, the trenches are located in the right 1/3 part of the VLD/JTE terminal region 20, and the beneficial effects of such arrangement are the same as described in the related part above. More preferably, the trench 50 is formed substantially at the center of each field limiting ring, or spans two adjacent field limiting rings and is formed substantially at the center of the two adjacent field limiting rings, and this is more beneficial to increasing the junction depth, thereby increasing the curvature radius and finally increasing the breakdown voltage of the device.

In some embodiments, the terminal region is a JTE terminal region, and the trench is formed substantially at the center of the JTE terminal region.

The trench structure is a grooved region extending from the front surface of the substrate to the back surface of the substrate, and the trench may be cuboid as shown in FIG. 1 and FIG. 2, or square or elliptical or semicircular in shape.

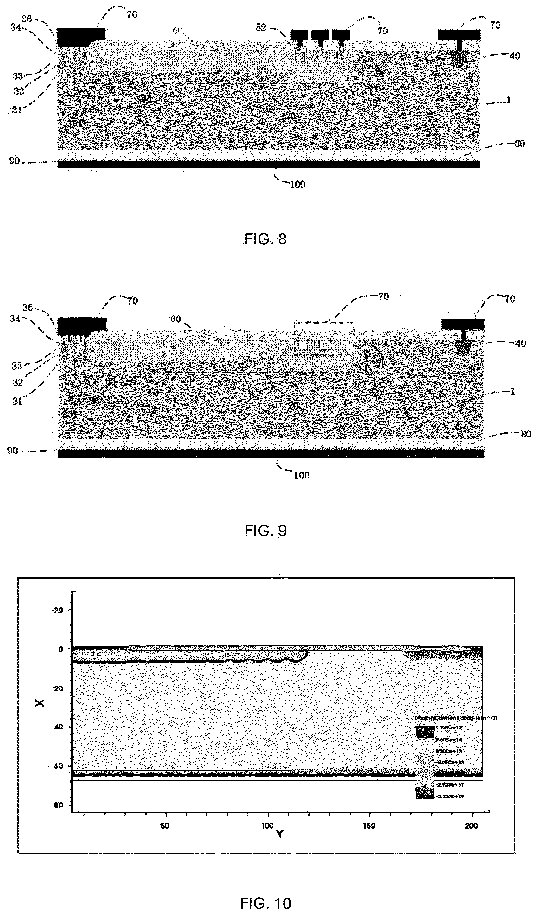

In some embodiments, as shown in FIG. 9, an inner wall of the trench 50 is formed with an oxide layer 51, but not filled with polysilicon, and it is simply to change a planar field oxide layer into a folded field oxide layer. By simply forming the oxide layer, the VLD junction depth below the trench can be increased by forming the folded oxide layer without introducing a field plate.

In some embodiments, as shown in FIG. 8, the inner wall of the trench 50 is formed with an oxide layer 51 and polysilicon 52 on the oxide layer. The polysilicon mainly functions to form a floating field plate so as to optimize the charge distribution of the oxide layer below the polysilicon.

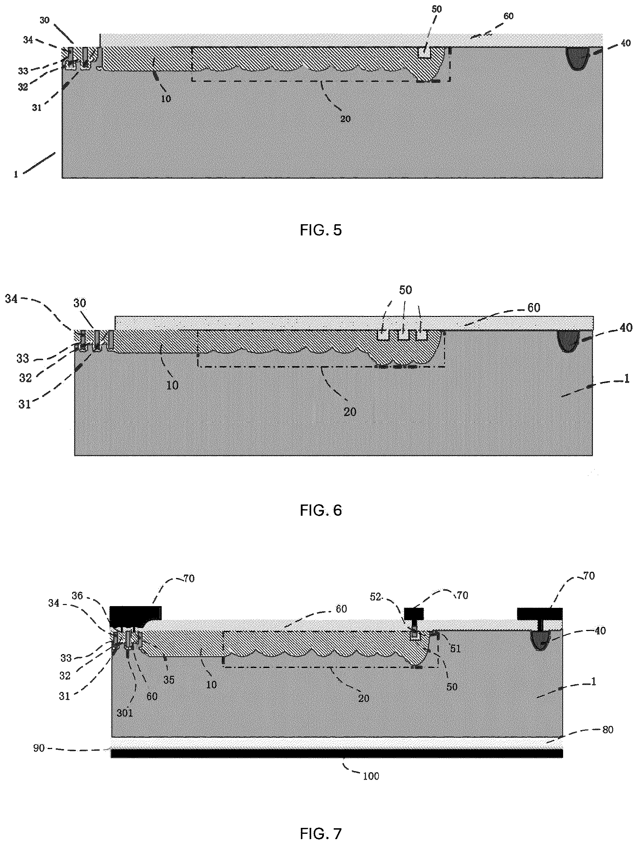

In some embodiments, as shown in FIG. 5 and FIG. 6, the semiconductor device may further include an active area 30. The active area 30 is arranged on the substrate 1 adjacent to the front surface on a side opposite to the main junction region 10 and the terminal region 20, i.e., on the left side of the main junction region 10. The active area 30 may include a P-type body region layer 31, a carrier storage layer 32, a gate oxide layer 33 and a polysilicon trench gate 34.

In some embodiments, as shown in FIG. 3 and FIG. 4, the semiconductor device may further include a field oxide layer 60. The field oxide layer 60 is arranged on the front surface of the substrate 1 and covers the active area 30, the main junction 10, the terminal region 20, the trenches 50 and the field cut-off region 40.

In some embodiments, as shown in FIG. 7 and FIG. 8, the semiconductor device may further include a contact hole 35 corresponding to the source region 30 and an N source region 36 formed on the contact hole 35. A metal layer 70 may be formed on the N source region 36, the polysilicon 52 and the field cut-off region 40. The metal layer 70 is usually formed by Al, AlSiCu or AlCu.

In some embodiments, the semiconductor device further includes a buffer layer 80, a P-type emitter layer 90 and a back surface metal layer 100. The buffer layer 80 is arranged on the back surface of the substrate 1. The P-type emitter layer 90 is arranged on the buffer layer 80. The back surface metal layer 100 is arranged on the P-type emitter layer 90. The back surface metal layer 100 is usually formed by Al, TI, NIV or AG.

Another aspect of the present disclosure provides a manufacturing method of the above semiconductor device of the present disclosure.

The manufacturing method includes steps S1 to S3 as follows.

Step S1: Providing a substrate 1 having a front surface and a back surface opposite to each other.

Step S2: Forming at least one trench 50 on the front surface of the substrate 1 corresponding to a position in a terminal region 20 close to a field cut-off region 40. The trench 50 may be formed by a known process, for example, an etching process.

Step S3: Sequentially implanting ions in the substrate 1 close to the front surface along a first direction parallel with the front surface to form a main junction region 10, a terminal region 20 and a field cut-off region 40. FIG. 1 and FIG. 2 show the schematic views after the main junction region 10, the terminal region 20 and the field cut-off region 40 are formed by ion implantation but before heat diffusion is performed, respectively after the formation of one and three trenches.

Field limiting rings are formed in the terminal region. At least a part of the field limiting rings surround the trench, and a junction depth of the field limiting ring surrounding the trench is greater than a junction depth of the field limiting ring not surrounding the trench.

Compared with the related art, in the present disclosure, before the formation of the main junction region and the terminal region by ion implantation, the trench structure is first formed corresponding to the position in the implantation region of the terminal region close to the field cut-off region, and then the main junction region, the terminal region and the field cut-off region are formed. By adding the trench structure, the depth of ion implantation can be increased, so that a larger junction depth can be formed subsequently.

In some embodiments, the manufacturing method further include S4: perform junction pushing on the main junction region 10, the terminal region 20 and the field cut-off region 40 by heat diffusion (e.g., furnace tube heat diffusion) (as shown in FIG. 3 and FIG. 4) such that the junction depths of all the field limiting rings in the terminal region are further increased. After the junction pushing is finally completed, the junction depth of the field limiting ring surrounding the trench shifts downward due to the presence of the trench, and thus is greater than the junction depth of the field limiting ring not surrounding the trench. The junction depth in the region where the trench structure is added is larger than that in the region where there is no trench, so that the curvature radius of the spherical junction is larger, and finally, the breakdown voltage is higher. A field oxide layer 60 may further be formed on the front surface of the substrate 1 (as shown in FIG. 3 and FIG. 4).

In some embodiments, the terminal region is a variable lateral doping terminal region, and the variable lateral doping terminal region includes a plurality of field limiting rings arranged side by side from a side close to the field cut-off region to a side of the main junction region along the first direction. The plurality of field limiting rings are formed by the following steps: arranging a plurality of masks 22 on the front surface of the substrate at intervals at positions corresponding to the terminal region; and implanting ions through implantation windows between the adjacent masks to form the plurality of field limiting rings. The trench is formed in the implantation window on the side close to the field cut-off region before the ions are implanted.

In some embodiments, the trench is formed in one of the windows or in each of the plurality of windows. For example, as shown in FIG. 1, the terminal region includes a first-from-right field limiting ring, a second-from-right field limiting ring, a third-from-right field limiting ring, a fourth-from-right field limiting ring, etc. from right to left. In the case where one trench is formed, FIG. 1 shows that the trench is formed in the first-from-right field limiting ring. Of course, the trench may also be formed in the second-from-right field limiting ring. Preferably, the field limiting ring where the trench is located is within the right 1/3 part of the terminal region. The beneficial effects of this arrangement are as described above. In the case where a plurality of trenches are formed, as shown in FIG. 3, three trenches are formed, and these three trenches are shown in the figure as being respectively formed in the three field limiting rings on the right side. Of course, these three trenches may also be respectively formed in the second-from-right to fourth-from-right field limiting rings. Similarly, these three trenches are preferably formed in the right 1/3 part of the terminal region.

In some embodiments, the trench is formed to span two adjacent implantation windows.

For example, for the VLD, the position where the trench is formed at least partially overlaps with the two adjacent VLD implantation windows, and the overlap is preferably less than 50% of a sum of widths of the two adjacent implantation windows. As shown in FIG. 1, a single trench is first formed and located between two adjacent VLD implantation windows, and the position of the trench overlaps with both of the two adjacent implantation windows in the X direction. After the trench structure is formed, ions are implanted through the implantation windows by the VLD, thereby forming the doping profile as shown in FIG. 1. The center of each implantation window in the VLD corresponds to the peak of the doping profile of the finally formed terminal region, and also corresponds to the peak of the junction depth. Preferably, the width of the trench structure is greater than an interval between the two adjacent VLD implantation windows (i.e., the width of the mask) and less than 50% of the sum of the widths of the two adjacent implantation windows spanned by the trench. Alternatively, the width of a single trench structure may be greater than two or three times the interval between the VLD implantation windows.

In some embodiments, the terminal region is a junction termination extension terminal region, and the trench is formed in a central region of the junction termination extension terminal region. This is more beneficial to increasing the junction depth, thereby increasing the curvature radius and finally increasing the breakdown voltage of the device.

In some embodiments, the manufacturing method further includes S5: form an active area 30 on the substrate 1 adjacent to the front surface on a side opposite to the main junction region 10 and the terminal region 20, including completing a P-type body region layer 31, a carrier storage layer 32, a gate oxide layer 33, a polysilicon trench gate 34, a contact hole 35, an N source region 36 and a front surface metal layer 70 (as shown in FIG. 5 to FIG. 8).

In some embodiments, the manufacturing method further includes S6: sequentially form a buffer layer 80, a P-type emitter layer 90 and a back surface metal layer 100 on the back surface of the substrate 1.

According to the semiconductor device and the manufacturing method thereof of the present disclosure, by arranging the trench structures in the VLD region or JTE region, the depth of ion implantation can be increased, so that a larger junction depth can be formed subsequently. The larger junction depth can reduce a peak electric field strength on the surface; the peak electric field strength shifts from the surface to the inside of silicon; and the curvature radius of the terminal P-type implantation region is increased, thereby increasing the breakdown voltage (BV) of the terminal structure.

Performance testing

The semiconductor devices of the related art and the present disclosure will be tested below for their performance such as breakdown voltage, doping profile and electric field distribution by using simulation technology.

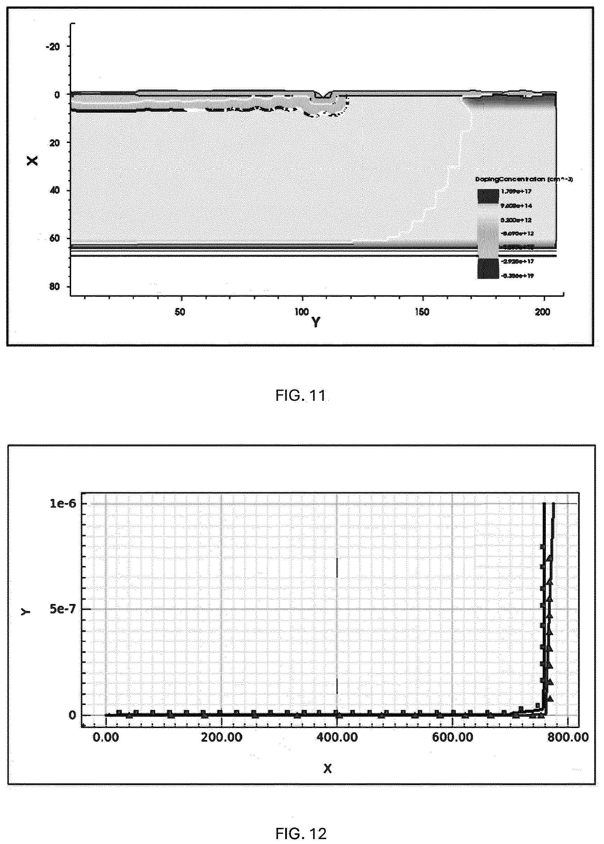

FIG. 10 shows a schematic structural view of a terminal region not formed with a trench in the related art semiconductor device. FIG. 11 shows a schematic structural view of a terminal region not formed with a trench in the semiconductor device of the present disclosure, where the terminal region is formed with one trench.

FIG. 12 shows a breakdown voltage comparison diagram of the terminal structure (indicated by the curve where the squares are located) not formed with a trench in the related art in FIG. 10 and the terminal structure (indicated by the curve where the triangles are located) formed with a trench in the present disclosure in FIG. 11. As can be seen from the figures, when Ices=1uA, the breakdown voltage of the terminal structure formed with one trench in the present disclosure is more than ten volts higher than the breakdown voltage (BV) of the terminal structure not formed with a trench in the related art, so the breakdown voltage is greatly increased.

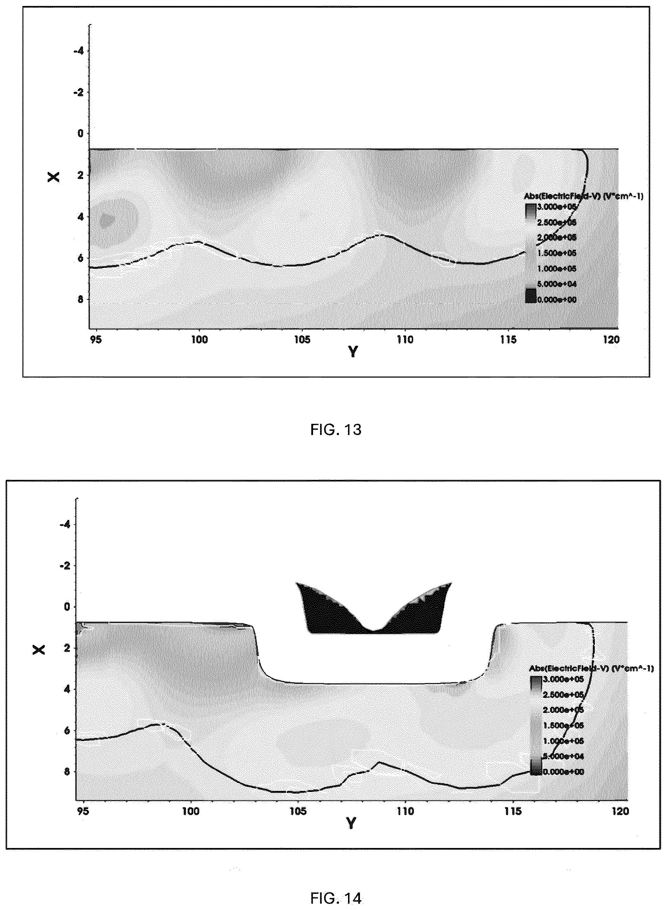

FIG. 13 shows an electric field distribution diagram of the terminal region structure not formed with a trench in the related art in FIG. 10. FIG. 14 shows an electric field distribution diagram of the terminal region structure formed with a trench in the present disclosure in FIG. 11. As can be seen from the comparison of electric field strength shown in FIG. 13 and FIG. 14, after the trench is added to the terminal region of the semiconductor device of the present disclosure, the surface electric field peak is reduced, and the maximum electric field shifts to the bottom of the trench.

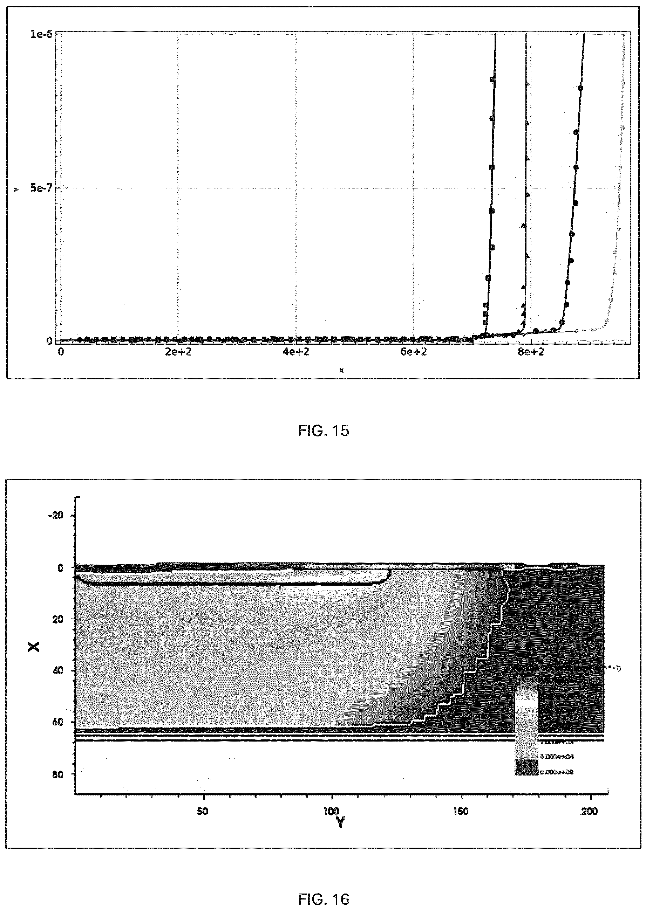

FIG. 15 shows a breakdown voltage comparison diagram of the terminal structure not formed with a trench in the related art and the terminal structure formed with a trench with different depths in the present disclosure, where the curve where the squares are located on the leftmost side indicates a breakdown voltage curve of the VLD structure not formed with a trench, the curve where the triangles are located indicates a breakdown voltage curve of the VLD structure formed with a trench with a depth of 5 $\mu$m, the curve where the circles are located indicates a breakdown voltage curve of the VLD structure formed with a trench with a depth of 3 $\mu$m, and the curve where the rhombi are located on the rightmost side indicates a breakdown voltage curve of the VLD structure formed with a trench with a depth of 4 $\mu$m.

As can be seen from the figure, after the trench structure is added, the breakdown voltage is increased as compared with the related art. In addition, it can also be seen that when the depth of the trench is around 4 $\mu$m, the breakdown voltage is increased more significantly.

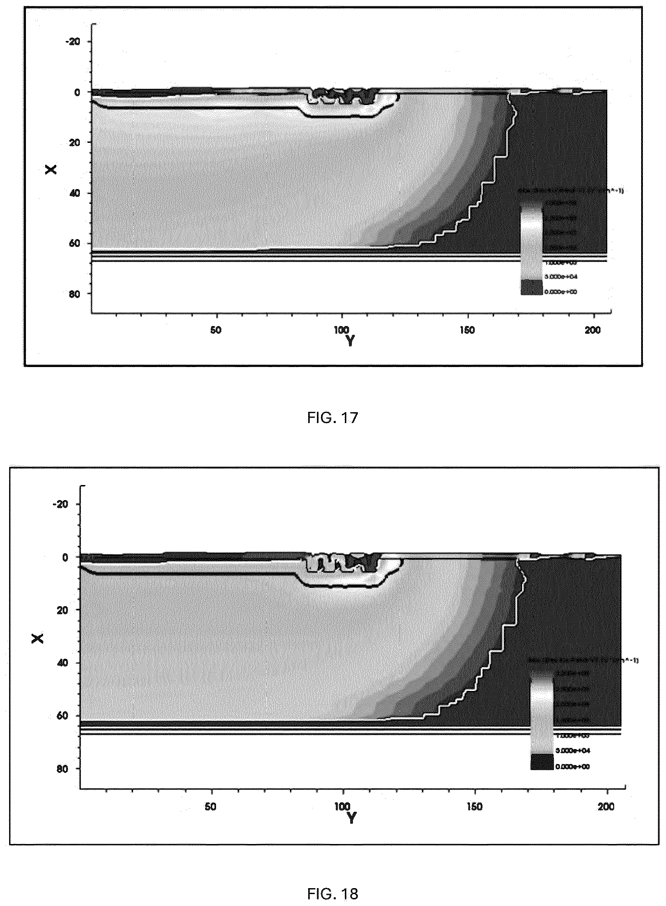

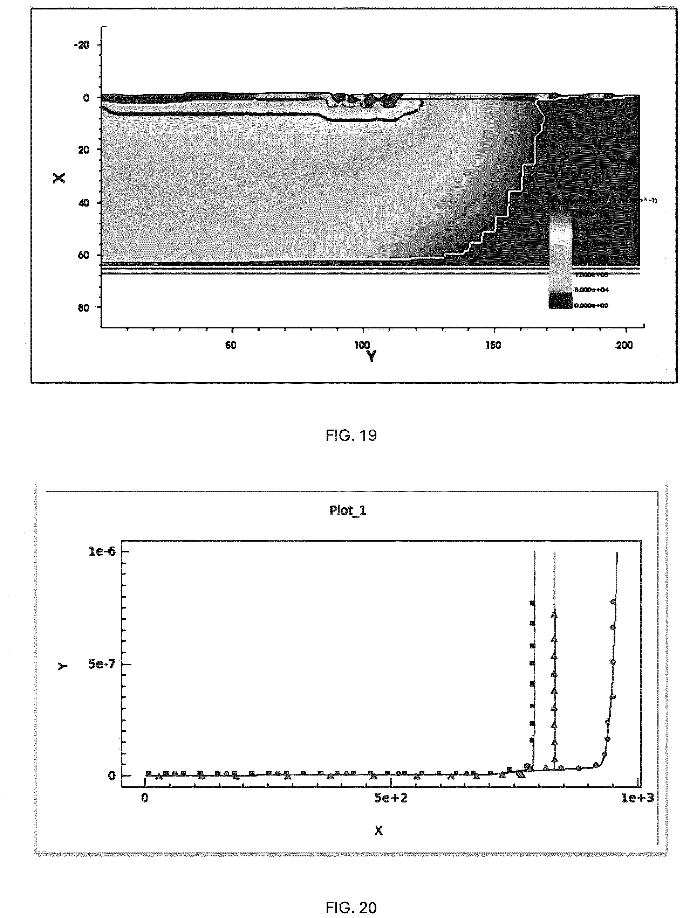

FIG. 16 shows an electric field distribution diagram of the terminal region structure not formed with a trench in the related art. FIG. 17 shows an electric field distribution diagram of the VLD/JET structure formed with a trench with a depth of 4 $\mu$m in the present disclosure. FIG. 18 shows an electric field distribution diagram of the terminal structure formed with a trench with a depth of 5 $\mu$m in the present disclosure. FIG. 19 shows an electric field distribution diagram of the terminal structure formed with a trench with a depth of 3 $\mu$m in the present disclosure. Except for the above differences, other structures and compositions of the semiconductor devices in FIG. 16 to FIG. 19 are the same. Similarly, when other aspects of the related art and the present disclosure are compared, except for the listed differences, other structures and compositions of the semiconductor devices are the same. As can be seen from FIG. 16 to FIG. 19, after the trench structure is added, the field distribution changes due to the introduction of the trench, the junction depth of the region with a trench shifts downward, and this can increase the curvature radius, thereby increasing the BV of the device.

FIG. 20 shows a breakdown voltage comparison diagram of the terminal structure not formed with a trench in the related art and the terminal structure formed with a plurality of trenches in the present disclosure, where the curve where the squares are located on the left side indicates a breakdown voltage curve of the VLD structure not formed with a trench, the curve where the triangles are located indicates a breakdown voltage curve of the VLD structure formed with a plurality of trenches having a constant spacing therebetween and gradually decreasing widths from left to right, and the curve where the circles are located indicates a breakdown voltage curve of the VLD structure formed with a plurality of trenches having a constant spacing therebetween and gradually increasing widths from left to right. As can be seen from the figure, the breakdown voltage of the semiconductor devices formed with a plurality of trenches can be increased. In addition, in the case where there are a plurality of trenches, under the same conditions, the breakdown voltage of the semiconductor device formed with trenches with gradually increasing widths from left (close to the active area) to right (close to the field cut-off region) is increased more significantly.

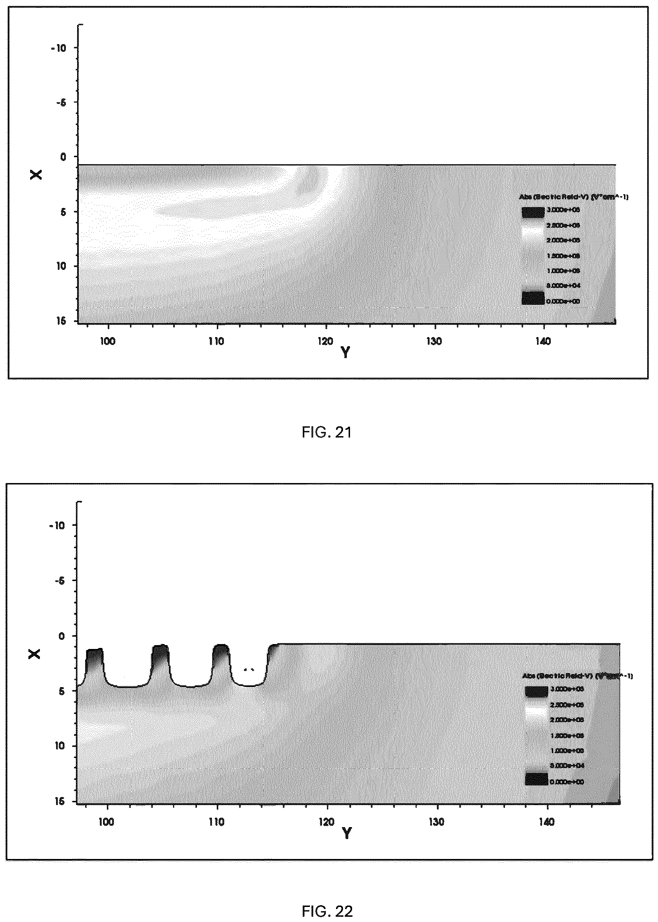

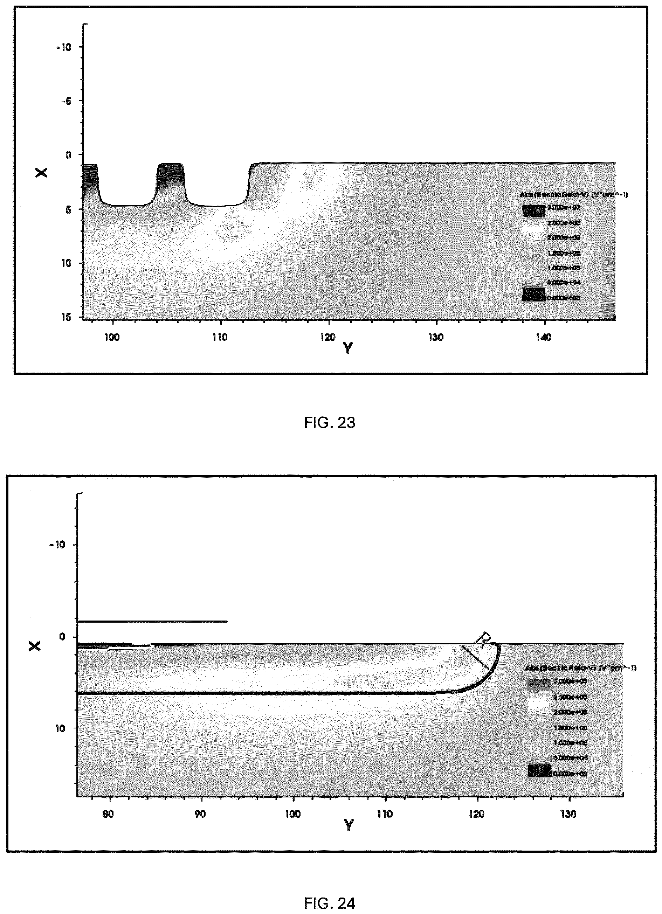

FIG. 21 shows an electric field distribution diagram of the VLD/JET region structure not formed with a trench in the related art. FIG. 22 shows an electric field distribution diagram of the VLD/JET structure formed with a plurality of trenches in the present disclosure, where spacings between the trenches are kept constant and widths of the trenches gradually decrease from left (close to the active area) to right (close to the field cut-off region). FIG. 23 shows an electric field distribution diagram of the VLD/JET structure formed with a plurality of trenches in the present disclosure, where spacings between the trenches are kept constant and widths of the trenches gradually increase from left (close to the active area) to right (close to the field cut-off region). As can be seen from FIG. 21 to FIG. 23, there is a maximum electric field peak at the interface between silicon dioxide and silicon in the VLD structure not formed with a trench structure, and after the trench structures are added, the maximum electric field shifts to the inside of silicon (i.e., the bottoms of the trenches), so that the breakdown voltage of the terminal structure can be increased.

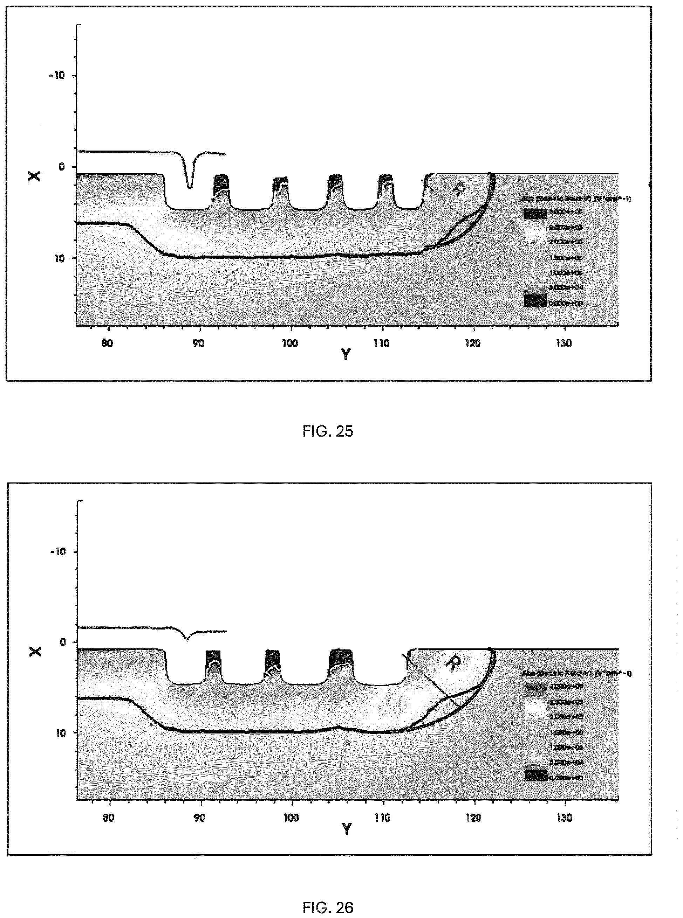

FIG. 24 shows a curvature radius of a spherical junction of the VLD/JET region structure not formed with a trench in the related art. FIG. 25 shows a curvature radius of a spherical junction of the VLD/JET structure formed with 5 trenches in the present disclosure. FIG. 26 shows a curvature radius of a spherical junction of the VLD/JET structure formed with 4 trenches in the present disclosure. FIG. 27 shows a curvature radius of a spherical junction of the VLD/JET structure formed with 3 trenches in the present disclosure. As can be seen from FIG. 25 to FIG. 27, in the case where other structures are the same, when the number of trenches increases from 3 to 5, the larger the number of trenches, the larger the curvature radius. This is because after the number of trenches increases, the total area or lateral width increased of the junction depth of the terminal region becomes larger, and this leads to the increase of the curvature radius and thus the increase of the final breakdown voltage of the device.

As shown in FIG. 24 to FIG. 27, R is the curvature radius. As can be seen from the figures, after the trench structures are added in the terminal region, the curvature decreases, and the curvature radius increases, i.e., the critical breakdown upper limit of the spherical junction of the terminal region increases due to the increase of the curvature radius. This is because, as can be seen from formulae (1) and (2), the curvature radius is directly proportional to the final breakdown voltage. As a result, the breakdown voltage of the semiconductor device of the present disclosure can be increased.

$$\frac{V_{\mathrm{B,SP}}}{V_{\mathrm{B,P}}} = \eta^2 + 2.14\eta^{6/7} - (\eta^3 + 3\eta^{13/7})^{2/3} \qquad (1)$$

$$\eta = R/W \quad (2)$$

where

$V_{B,SP}$ is the breakdown voltage of the spherical junction;
$V_{B,P}$ is the breakdown voltage of the planar junction;
$\eta$ is the normalized curvature radius;
$R$ is the curvature radius of the spherical junction; and
$W$ is the width of the junction depletion layer when breakdown occurs to an ideal planar junction.

It should be understood that the arrangement of components shown in the accompanying drawings is for illustrative purposes, and other arrangements are possible.

In addition, the embodiments and examples described herein are merely for illustrative purposes, and those skilled in the art can think of various modifications and variations. These modifications and variations are also included in the spirit and scope of this application and the appended claims.

Table 1 below is a list of components and corresponding reference signs in the accompanying drawings, where the same or similar reference numerals denote the same or similar components in the accompanying drawings. Therefore, once a component is defined in one embodiment, further definition and explanation may be omitted in other embodiments.

| Reference numerals | Component name |
| --- | --- |
| 1 | Substrate |
| 10 | Main junction region |
| 20 | Terminal region |
| 21; 21-1; 21-2; 21-3 | Field limiting ring |
| 30 | Active area |
| 31 | P-type body region layer |
| 32 | Carrier storage layer |
| 33 | Gate oxide layer |
| 34 | Polysilicon trench gate |
| 35 | Contact hole |
| 36 | N source region |
| 40 | Field cut-off region |
| 50 | Trench |
| 51 | Oxide layer |
| 52 | Polysilicon |
| 60 | Field oxide layer |
| 70 | Metal layer |
| 80 | Buffer layer |
| 90 | P-type emitter layer |
| 100 | Back surface metal layer |
| X | First direction |
| h1 | Junction depth |

(continued)

| Reference numerals | Component name |
|---|---|
| R | Curvature radius |

**Claims**

1. A semiconductor device, comprising:

    a substrate having a front surface and a back surface opposite to each other;
    a main junction region, a terminal region and a field cut-off region sequentially arranged in the substrate close to the front surface along a first direction parallel with the front surface; and
    at least one trench formed in the terminal region at a position close to the field cut-off region,
    wherein field limiting rings are formed in the terminal region, at least a part of the field limiting rings surround the trench, and a junction depth of the field limiting ring surrounding the trench is greater than a junction depth of the field limiting ring not surrounding the trench.

2. The semiconductor device according to claim 1, wherein

    the terminal region is a variable lateral doping terminal region, and the variable lateral doping terminal region comprises a plurality of field limiting rings; and
    a distance between a peak of a first field limiting ring surrounding the trench and closest to the main junction region and a peak of a second field limiting ring adjacent to the first field limiting ring but not surrounding the trench is T, and a distance between the peak of the second field limiting ring and a peak of a third field limiting ring in close proximity to the second field limiting ring but not surrounding the trench is D, a ratio T/D of the distance T to the distance D being greater than 0 and less than 0.35 or greater than 1 and less than 1.5, and
    preferably, the ratio T/D of the distance T to the distance D being greater than 0 and less than 0.2 or greater than 1 and less than 1.3.

3. The semiconductor device according to claim 1, wherein the terminal region is a variable lateral doping terminal region, and the variable lateral doping terminal region comprises a plurality of field limiting rings; and

    a curvature of the field limiting ring surrounding the trench changes at a position corresponding to a trench sidewall of the trench closest to the main junction region, and
    preferably, the curvature decreases.

4. The semiconductor device according to claim 1, wherein the terminal region is a variable lateral doping terminal region, and the variable lateral doping terminal region comprises a plurality of field limiting rings; and

    an orientation of a curvature radius of the field limiting ring surrounding the trench deviates at a position corresponding to a trench sidewall of the trench closest to the main junction region, and
    preferably, the orientation of the curvature radius of the field limiting ring surrounding the trench starts to deviate from the position corresponding to the trench sidewall of the trench closest to the main junction region.

5. The semiconductor device according to any of claims 1 to 4, wherein the terminal region is the variable lateral doping terminal region, and the variable lateral doping terminal region comprises the plurality of field limiting rings; and a width of the trench is less than the distance between the peaks of the second field limiting ring and the third field limiting ring not surrounding the trench but adjacent to the first field limiting ring surrounding the trench and closest to the main junction region.

6. The semiconductor device according to any of claims 1 to 5, wherein there are two or more trenches sequentially arranged from the position of the terminal region close to the field cut-off region to the position close to the main junction region;

    preferably, spacings between the adjacent two trenches are the same; or monotonically increase, monotonically decrease, or increase first and then decrease along the first direction toward the field cut-off region; and

preferably, the spacings between the two adjacent trenches are 0.3-6 μm, preferably 0.5-4 μm.

7. The semiconductor device according to claim 6, wherein depths of the plurality of trenches are the same; or monotonically increase, monotonically decrease, or increase first and then decrease along the first direction toward the field cut-off region; and
preferably, widths of the plurality of trenches are the same; or monotonically increase, monotonically decrease, or increase first and then decrease along the first direction toward the field cut-off region.

8. The semiconductor device according to any of claim 1 to 7, wherein the depths of the trenches are 1-8 μm, preferably 2-6 μm, and the widths of the trenches are 0.4-8 μm, preferably 0.6-5 μm.

9. A method for manufacturing a semiconductor device, comprising the following steps:

providing a substrate having a front surface and a back surface opposite to each other;
forming at least one trench in the front surface of the substrate corresponding to a position in a terminal region close to a field cut-off region; and
sequentially implanting ions in the front surface of the substrate along a first direction parallel with the front surface to form a main junction region, the terminal region and the field cut-off region,
wherein field limiting rings are formed in the terminal region, at least a part of the field limiting rings surround the trench, and a junction depth of the field limiting ring surrounding the trench is greater than a junction depth of the field limiting ring not surrounding the trench.

10. The manufacturing method according to claim 9, further comprising:
performing junction pushing on the main junction region, the terminal region and the field cut-off region by heat diffusion such that the junction depths of all the field limiting rings in the terminal region are further increased, and the junction depth of the field limiting ring surrounding the trench is greater than the junction depth of the field limiting ring not surrounding the trench.

11. The manufacturing method according to claim 9 or 10, wherein the terminal region is a variable lateral doping terminal region, and the variable lateral doping terminal region comprises a plurality of field limiting rings arranged side by side from a side close to the field cut-off region to a side of the main junction region along the first direction, the plurality of field limiting rings being formed by the following steps:

arranging a plurality of masks on the front surface of the substrate at intervals at positions corresponding to the terminal region; and
implanting ions through implantation windows between the adjacent masks to form the plurality of field limiting rings,
wherein the trench is formed in the implantation window on the side close to the field cut-off region before the ions are implanted.

12. The manufacturing method according to claim 11, wherein the trench is formed in one of the windows or in each of the plurality of windows.

13. The manufacturing method according to claim 11, wherein the trench is formed to span two adjacent implantation windows; and
preferably, a width of the trench is greater than a width of the mask and less than 50% of a sum of widths of the two adjacent implantation windows spanned by the trench.

14. The manufacturing method according to claim 9 or 10, wherein the terminal region is a junction termination extension terminal region, and the trench is formed in a central region of the junction termination extension terminal region.

FIG. 1

FIG. 2

FIG. 3

50

FIG. 3A

50

60

40

10

20

1

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

# EUROPEAN SEARCH REPORT

**Application Number**

EP 24 21 2741

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 203 134 805 U (INST OF MICROELECTRONICS CAS ET AL.) 14 August 2013 (2013-08-14) | 1,9,10 | INV.<br>H10D62/10 |
| A | * Fig. 1 and correlated text passages * | 2-8,<br>11-14 | H10D30/01<br>H10D30/66<br>H10D64/00 |
| X | JP H07 142713 A (HITACHI LTD) 2 June 1995 (1995-06-02) | 1,6-10 | |
| A | * Fig. 3 and correlated text passages * | 2-5,<br>11-14 | |
| A | CN 106 783 957 A (UNIV XIDIAN) 31 May 2017 (2017-05-31) * the whole document * | 1-14 | |
| A | ALEXANDER V BOLOTNIKOV ET AL: "Junction Termination Extension Implementing Drive-in Diffusion of Boron for High-Voltage SiC Devices", IEEE TRANSACTIONS ON ELECTRON DEVICES, IEEE, USA, vol. 57, no. 8, 1 August 2010 (2010-08-01) , pages 1930-1935, XP011312445, ISSN: 0018-9383 * the whole document * | 1-14 | **TECHNICAL FIELDS SEARCHED (IPC)**<br><br>H10D |
| A | CN 216 250 741 U (BEIJING YANDONG MICROELECTRONIC SCIENCE AND TECH LIMITED COMPANY) 8 April 2022 (2022-04-08) * the whole document * | 1-14 | |

The present search report has been drawn up for all claims

| Place of search | Date of completion of the search | Examiner |
|---|---|---|
| Munich | 3 April 2025 | Melodia, Andrea |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 21 2741

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2025

| Patent document cited in search report | | Publication date | Patent family member(s) | | Publication date |
|---|---|---|---|---|---|
| CN 203134805 | U | 14-08-2013 | NONE | | |
| JP H07142713 | A | 02-06-1995 | JP | 3211490 B2 | 25-09-2001 |
| | | | JP | H07142713 A | 02-06-1995 |
| CN 106783957 | A | 31-05-2017 | NONE | | |
| CN 216250741 | U | 08-04-2022 | NONE | | |

EPO FORM P0459

For more details about this annex : see Official Journal of the European Patent Office, No. 12/82